# EUROPÄISCHE PATENTANMELDUNG

(11) **EP 2 634 822 A1**
(43) Veröffentlichungstag der Anmeldung: **04.09.2013**
(21) Anmeldenummer: 12001365.1
(22) Anmeldetag: 29.02.2012
(51) Int. Cl.: H01L 31/18, H01L 31/05, B23K 1/00, B23K 3/00

(54) **Vorrichtung zum Lagefixieren eines Lötverbinders auf einer Solarzelle**

(71) Anmelder: IMA Automation Berlin GmbH, 12623 Berlin (DE)
(72) Erfinder: Nowak, Andreas, 16341 Panketal (DE)
(74) Vertreter: Hannig, Wolf-Dieter

(57) **Zusammenfassung**

Die Erfindung betrifft eine Vorrichtung zum Lagefixieren eines Verbinders (3) aus verzinntem Lötband auf einer Solarzelle (2) mittels eines auf den Verbinder (3) absenkbaren Niederhalters (N) beim Transport in einer Fertigungsanlage zur Herstellung von Solarzellenstrings, mit einem von einem Antrieb angetriebenen Transportband (1) zum Bewegen von Solarzelle (2) und Verbinder (3) zu einer Bearbeitungsstation, wobei der zum Transportband (1) synchron bewegte Niederhalter (N) ein mit Niederhalteelemente versehenen Rahmen (4) aufweist.

## Beschreibung

Die Erfindung betrifft eine Vorrichtung zum Lagefixieren eines Verbinders aus verzinntem Lötband auf einer Solarzelle mittels eines auf den Verbinder absenkbaren Niederhalters beim Transport in einer Fertigungsanlage zur Herstellung von Solarzellenstrings, mit einem von einem Antrieb angetriebenen Transportband zum Bewegen von Solarzelle und Verbinder zu einer Bearbeitungsstation, wobei der zum Transportband synchron bewegte Niederhalter ein mit Niederhalteelemente versehenen Rahmen aufweist.

### Stand der Technik

Aus der DE 10 2006 007 447 A1 ist eine Streifen-Niederhaltevorrichtung bekannt, die die auf die Solarzelle abgelegten Verbinder andrücken und fixieren. Das entsprechende Niederhaltelement wird dann zusammen mit der Solarzelle weitertransportiert und nach Durchlaufen der Lötstation wieder abgehoben. Diese bekannte Niederhaltevorrichtung besitzt einen Rahmen, der an seinen beiden Randbereichen Auflageflächen aufweist, die ausgelegt sind, um auf Transportbändern plan aufzuliegen, und der im mittleren Bereich ein Fenster aufweist. Es ist eine Vielzahl von Niederhalteköpfen vorgesehen, die in zumindest zwei Reihen seitlich des Fensters angeordnet sind, und jeweils eine Niederhaltenadel aufweisen, wobei die Niederhalteköpfe schwenkbar am Rahmen gehalten sind, derart, dass die Niederhaltenadeln auf einen Streifen unterhalb des Fensters bewegbar sind.
Von Nachteil ist, dass die Niederhalteköpfe in einem Drehlager am Rahmen angelenkt sind. Durch diese Art der Anlenkung ergibt sich beim Absenken am Auflagepunkt der Niederhaltenadel auf dem Verbinder neben der senkrechten Kraftkomponente auch eine horizontale Kraftkomponente infolge der Kreisbewegung am Drehlager, die sich in einer Horizontalbewegung äußert, wodurch das Risiko einer seitlichen Verschiebung der Verbinder auf der Solarzelle steigt.
Des Weiteren wird die Niederhaltekraft sowohl von den eingebauten Federn als auch durch die Reibung in den Drehlagern beeinflusst, die im Laufe der Anlagennutzung infolge der Verschmutzung zunimmt, so dass mit einer nicht mehr zu vernachlässigenden Streuung der Niederhaltekräfte gerechnet werden muss. Im Extremfall kann dies zu einer vollkommen unerwünschten Blockierung des Niederhalters führen.
Solarzellen reagieren bekanntlich sehr empfindlich auf mechanische Belastungen, so dass die Qualität der Solarzellen negativ beeinflusst wird.
Ein weiterer Nachteil dieser bekannten Lösung besteht insbesondere beim Lichtlötverfahren darin, dass der Schattenwurf der Niederhalter die Lötergebnisse beeinflusst und für jeden Solarzellentyp ein neuer Niederhalter verwendet werden muss, weil die Lage und die Anzahl der Verbinder auf der Solarzelle typenabhängig variiert.

Eine andere bekannte Lösung (EP 2 269 757 A1) setzt Niederhaltestifte zum Niederhalten ein, die von oben auf den Verbinder aufgesetzt werden.
Auch bei dieser bekannten Lösung lässt sich die Gefahr der Verklemmung der Stifte in ihren Führungen nicht ausschließen, wodurch die Niederhaltefunktion eingeschränkt wird. Außerdem kann diese bekannte Lehre nur für bestimmte Lötverfahren, beispielsweise Induktionslöten, eingesetzt werden.

Weiterhin ist aus der DE 102 97 633 T5 ein Niederhalter in Form einer Niederhalteplatte bekannt, die auf den Verbinder abgesenkt wird und die entsprechende Freimachungen zum Ausführen der Lötung aufweist.
Dieser bekannte Stand der Technik hat den Nachteil, dass sich beim Auflegen der Niederhalteplatte infolge der Toleranzunterschiede in der Ebenheit von Platte und Auflage immer eine Punktberührung ergibt, wodurch an den Auflagepunkten eine erhöhte mechanische Belastung für die Solarzelle entsteht, was zu Qualitätseinbußen führt.
Darüber hinaus wird das Lötergebnis durch den Masseeintrag der Platte beeinflusst, weil die Platte bei Prozessbeginn aufgeheizt werden muss.
Für Lichtlötverfahren ist dieser Stand der Technik nicht einsetzbar.

### Aufgabenstellung

Bei diesem Stand der Technik liegt der Erfindung die Aufgabe zugrunde, eine Vorrichtung zum Lagefixieren eines Verbinders auf einer Solarzelle bereitzustellen, die es ermöglicht, eine quasi-lineare Andruckkraft sowohl quer als auch längs der Transportrichtung unabhängig voneinander auf den oder die Verbinder aufzubringen, Unebenheiten von Zellen und Verbindern an den Auflagepunkten auszugleichen und ein typenabhängiges Umrüsten der Niederhalter auf unterschiedliche Ablagepositionen und Abmessungen der Verbinder unter gleichzeitiger Erweiterung auf jegliche Lötverfahren bei Verringerung des maschinentechnischen Aufwandes, der Erhöhung des Durchsatzes und der Qualität sowie Beibehaltung einer hohen Flexibilität zu vermeiden.

Diese Aufgabe wird durch eine Vorrichtung der eingangs genannten Gattung mit den Merkmalen des Anspruchs 1 gelöst.

Vorteilhafte Ausgestaltungen der erfindungsgemäßen Vorrichtung sind den Unteransprüchen entnehmbar

Die erfindungsgemäße Lösung geht von der Erkenntnis aus, den Niederhalter als ein sowohl über die Länge eines einzelnen Verbinders als auch über mehrere nebeneinander angeordnete Verbinder übergreifendes gesamtelastisches System auszuführen, um eine quasi-lineare Vertikalbewegung ohne eine seitliche Verschiebebewegung auf den Verbinder aufzubringen. Dies wird dadurch erreicht, dass der Rahmen als ein mit seinen Längsseiten quer zur Transportrichtung des Transportbandes angeordneter federrostartiger geschlossener Spannrahmen ausgebildet ist, zwischen dessen parallel zur Transportband angeordnete Stirnseiten mindestens eine zum Verbinder quer und zugewandt verlaufende elastische Niederhaltelitze unter Spannung gehalten ist, und dass die Niederhaltelitze mindestens eine Kontakteinheit zum linearen Andrücken des Verbinders an die Solarzelle beim Absenken aufweist.
Der Rahmen kann nach einer Weiterentwicklung der Erfindung aber auch als ein entgegen der Transportrichtung offen gestalteter Spannrahmen ausgebildet sein. In diesem Fall besitzt der Rahmen nur eine Längsseite, die der Transportrichtung zugewandt ist. Eine derartige Ausführung des Spannrahmens hat den Vorteil, dass der Hubweg des Spannrahmens deutlich verringert werden kann.

In einer bevorzugten Ausführungsform der erfindungsgemäßen Vorrichtung ist eine Vielzahl von Niederhaltelitzen entsprechend der Länge der Verbinder in Transportrichtung hintereinander, aber voneinander beabstandet entlang der Stirnseiten des Rahmens angeordnet, wobei die in Richtung eines jeden Verbinders hintereinander liegenden Kontakteinheiten aller Niederhaltelitzen den jeweiligen Verbinder jeweils linear über seine Länge in Transportrichtung und die Kontakteinheiten einer Niederhaltelitze nebeneinander liegende Verbinder quer zur Transportrichtung jeweils über seine Breite unabhängig voneinander an die Solarzelle drücken.
Dies ist mit dem außerordentlichen Vorteil verbunden, dass durch die Unabhängigkeit der nebeneinander angeordneten Niederhaltelitzen Unebenheiten von Verbinder und Solarzelle ausgeglichen und zugleich mehrere nebeneinander auf der Solarzelle positionierte Verbinder quasi-linear quer und längs der Transportrichtung lagefixiert werden können.

Nach einer weiteren vorteilhaften Ausgestaltung der erfindungsgemäßen Vorrichtung ist jede Niederhaltelitze an ihrem einen Ende mit einer an der Stirnseite festgelegten Befestigungseinrichtung und an ihrem anderen Ende mit einer an der zweiten Stirnseite befestigten Kraftausgleichseinrichtung zum Einstellen der Spannkraft der Niederhaltelitze verbunden. Die Kraftausgleichseinrichtung hält unabhängig von äußeren Einflüssen die Vorspannung der Niederhaltelitze konstant.

In einer weiteren vorteilhaften Ausführungsform der erfindungsgemäßen Vorrichtung ist vorgesehen, dass der Rahmen ein weiteres von den Längsseiten und einer weiteren Stirnseite umgrenztes Aufnahmefeld für die Aufnahme der Kraftausgleichseinrichtungen ausbildet, die an einer quer zu den Längsseiten, in einer vom Transportband weg geneigten Ebene angeordneten Leiste befestigt sind.

Zum Konstanthalten der Vorspannung der Niederhaltelitze umfasst die Kraftausgleicheinrichtung:
a) eine Druckfeder, die an ihrem eine Ende in einem hülsenförmigen Zugglied gehalten und an ihrem anderen Ende an einem Befestigungsteil fixiert ist,
b) ein mit einer Einhängöffnung für die Niederhaltelitze versehenes Einhängteil, welches ein bolzenartiges Schaftteil mit Außengewinde aufweist, das in Achsrichtung des hülsenförmigen Zugglied in einer am Zugglied befestigten Mutter mit Innengewinde zum Einstellen der Vorspannung der Druckfeder einschraubbar gehalten ist.
Dies ermöglicht in vorteilhafter Weise, dass jede Kontakteinheit auf den jeweiligen Verbinder mit etwa gleicher Auflagekraft drückt, welche durch die Kraftausgleicheinrichtung auch bei äußerer Beeinflussung, beispielsweise durch eine Temperaturänderung, annähernd konstant gehalten wird.

Eine weitere Ausführungsvariante der Kraftausgleichseinrichtung sieht vorzugweise eine Zugfeder vor, deren eine Öse in einer Öffnung eines zu einer an der zweiten Stirnseite des Rahmens befestigten Leiste gehörenden in Richtung Transportband abgewinkelten Schenkels und dessen andere Öse in einer Öffnung eines mit dem Ende der Niederhaltelitze verstellbar verbundenen Zuggliedes eingehängt ist.

In weiterer bevorzugter Ausgestaltung der erfindungsgemäßen Vorrichtung ist die Kontakteinheit aus einem mit einer axialen Durchführung für die Niederhaltelitze versehenen Zylinderkörper gebildet, der auf die Niederhaltelitze aufgeschoben und entsprechend der Position des Verbinders auf der Solarzelle entlang der Niederhaltelitze einstell- und fixierbar ist.
Dies wird dadurch ermöglicht, dass im Zylinder eine senkrecht zur Durchführung angeordnete Bohrung mit Innengewinde angeordnet ist, in das eine Feststellschraube zum Fixieren der Kontakteinheit an der Niederhaltelitze einschraubbar ist, wodurch die Kontakteinheit mehrfach verwendet werden kann. Von besonderem Vorteil ist dabei, dass die Lage und Position der Kontakteinheiten entlang der Niederhaltelitze auf verschiedenartige Typen von Verbindern entsprechend den unterschiedlichen Breiten- und Längenabmessungen einstellbar ist, ohne eine Umrüstung auf andere Niederhalter vornehmen zu müssen. Durch die Längenvariabilität der Zylinder ist außerdem gewährleistet, dass verschieden breite Verbinder zum Einsatz kommen können.

In einer weiteren bevorzugten Ausführungsvariante der Erfindung ist die Kontakteinheit als ein eine axiale Durchführung aufweisender Walzenkörper mit mindestens einem an einer Stirnseite angeformten Zapfen ausgebildet, wobei der Zapfen dünnwandig und so deformierbar ist, dass er durch eine von außen aufgebrachte Verformungskraft auf der Niederhaltelitze entsprechend der Position der Verbinder geklemmt und damit einwegartig an der Niederhaltelitze fixiert werden kann.

Der Zylinderkörper oder Walzenkörper ist durchmesser- und längenvariabel und besteht aus einem beim Löten temperaturbeständigen Werkstoff, vorzugsweise Edelstahl.

Eine weitere bevorzugte Ausgestaltungsform der erfindungsgemäßen Vorrichtung sieht vor, dass die Befestigungseinrichtung für die Niederhaltelitze eine an der zur Solarzelle abgewandten Oberseite der Stirnseite befestigte Klemmanordnung mit einer Durchführung umfasst, in die das Ende der Niederhaltelitze einsteck- und hindurchführbar ist, wobei die Niederhaltelitze durch eine in eine senkrecht zur Durchführung eingebrachte Bohrung mit Innengewinde eingeschraubte Feststellschraube fixierbar ist. Zweckmäßigerweise ist die Klemmanordnung als eine Leiste ausgebildet, an der Klemmstücke befestigt sind, die entlang der ersten Stirnseite des Spannrahmens positioniert sind.
Es ist aber auch möglich die Klemmanordnung an der der Solarzelle abgewandten Oberseite in die Stirnseite zu integrierten.
Damit ist gewährleistet, dass problemlos mehrere Befestigungseinrichtungen hintereinander entsprechend der Anzahl der zu befestigenden Niederhaltelitzen angeordnet werden können.

Die Niederhaltelitze besteht vorzugsweise aus einem Material, das elastische Eigenschaften auch bei höheren Temperaturen, vorzugsweise Löttemperaturen, besitzt und ständig unter Vorspannung gehalten werden kann. Besonders geeignet sind Niederhaltelitzen aus geflochtenen Metallfäden, insbesondere Edelstahlfäden, temperaturbeständige Kunststofffäden oder Fäden aus Kompositwerkstoffen.

In einer weiteren bevorzugten Ausführungsform der erfindungsgemäßen Vorrichtung ist vorgesehen, dass der Spannrahmen mit senkrecht zur Transportrichtung angeordnete Säulen und einem Antrieb zum vertikalem Absenken oder Abheben auf die bzw. von den Solarzellen versehen ist, wobei Spannrahmen, Führungssäulen und Antrieb in einer in Transportrichtung horizontal verlaufenden Linearführung durch einen mit dem Antrieb des Transportbandes synchronisierten Antrieb geführt sind.
Als Antrieb für den Spannrahmen hat sich besonders ein pneumatischer Antrieb als geeignet erwiesen. Andere Antriebe, beispielsweise hydraulischer oder elektrischer Art, sind ebenso geeignet.

Weitere Vorteile und Einzelheiten der Erfindung ergeben sich aus der nachfolgenden Beschreibung unter Bezugnahme auf die beigefügten Zeichnungen.

### Ausführungsbeispiel

Die Erfindung soll nachstehend an einem Ausführungsbeispiel näher erläutert werden.
Es zeigen

Fig. 1 eine perspektivische Darstellung der erfindungsgemäßen Vorrichtung, die auf eine mit Verbindern versehene Solarzelle aufgesetzt ist,

Fig. 2a und 2b einen Schnitt durch unterschiedlich ausgebildete Kontakteinheiten,

Fig. 3 einen Schnitt durch die Befestigungseinrichtung,

Fig. 4a und 4b verschiedene Varianten der Kraftausgleichseinrichtung in Schnittdarstellung und

Fig. 5 einen Schnitt entlang der Linie A-A nach Fig. 1.

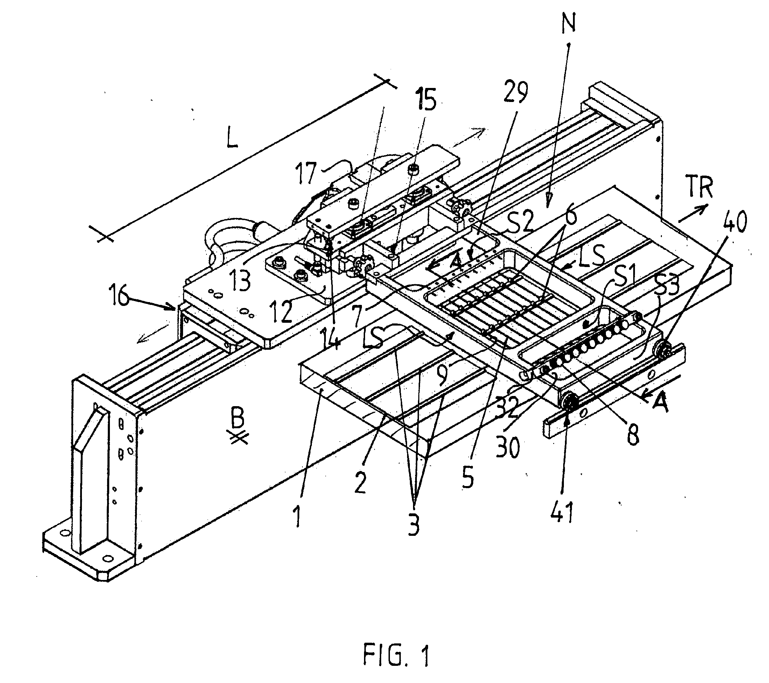

Die Fig. 1 zeigt ein Transportband 1 einer weiter nicht dargestellten Bearbeitungsvorrichtung für Solarzellen 2, die auf dem Transportband 1 aufliegen. Die Transsportrichtung ist mit dem Bezugszeichen TR bezeichnet. Auf der Solarzelle 2 sind beispielsweise in Transportrichtung TR drei voneinander beabstandete Verbinder 3 mit der Länge L und der Breite B in der für die Lötung vorgesehenen Position abgelegt.

Die erfindungsgemäße Vorrichtung zum Lagefixieren der Verbinder 3 auf der Solarzelle 2 setzt sich im Wesentlichen aus einem Rechteck-Spannrahmen 4, elastischen Niederhaltelitzen 5, Kontakteinheiten 6, Befestigungseinrichtungen 7 und Kraftausgleichseinrichtungen 8 für die Niederhaltelitzen 5 zusammen. Die Längsseiten LS des Spannrahmens 4 sind quer und die Stirnseiten S1 und S2 des Spannrahmens 4 parallel zur Transportrichtung TR ausgerichtet. Die innere Stirnseite S1 und eine erste Stirnseite S2 spannen zusammen mit den Längsseiten LS ein Rahmenfeld 9 über der Solarzelle 2 auf, wobei der Rechteck-Spannrahmen 4 so ausgelegt ist, dass das Rahmenfeld 9 die Solarzelle 2 überdeckt und die gesamte Breite der Solarzelle 2 freigibt.

Die der Stirnseite S2 des Spannrahmens 4 zugeordneten Längsseiten LS des Spannrahmens 4 sind als Haltearme 29 ausgebildet, die an einem gegenüber dem Transportband 1 überkragenden Halteelement 12 befestigt sind, das senkrecht zur Transportrichtung TR angeordnete Säulen 13 aufweist, die in Führungen 14 geführt sind. Das vertikale Absenken bzw. Anheben der erfindungsgemäßen Vorrichtung auf bzw. von dem Verbinder wird von einem pneumatischen Antrieb 15 bewerkstelligt. Der Spannrahmen 4 mit Befestigungseinrichtungen 7, Kraftausgleichseinrichtungen 8, Kontakteinheiten 6, Säulen 13 und Antrieb 15 werden in einem horizontal angeordneten Linearsystem 16 geführt und von einem mit dem Antrieb des Transportbandes synchronisierten Antrieb 17 angetrieben.
Der Spannrahmen 4 umfasst ein weiteres Aufnahmefeld 30, welche durch die Verlängerung der Längsseiten LS nach außen und einer äußeren Stirnseite S3 gebildet ist. In diesem Aufnahmefeld 30 sind die Kraftausgleichrichtungen 8 positioniert.
An der Stirnseite S3 des Rahmens 4 sind Laufrollen 40 drehbar gelagert, die auf einer an der Bearbeitungsvorrichtung befestigen Schiene 42 verfahrbar sind.

Die Niederhaltelitzen 5 sind federrostähnlich hintereinander in Transportrichtung TR voneinander beabstandet jeweils an den sich gegenüberliegenden, der Solarzelle 2 zugewandten Seite der Stirnseiten S1 und S2 des Spannrahmens 4 angeordnet. Jeder Niederhaltelitze 5 ist je eine Befestigungseinrichtung 7, eine Kraftausgleichseinrichtung 8 und mindestens eine Kontakteinheit 6 zugeordnet, wobei die Befestigungseinrichtung 7 und die Kraftausgleichseinrichtung 8 in Flucht zueinander gegenüberliegend an den jeweiligen Stirnseiten S2 und S1 des Spannrahmens 4 positioniert sind. Die Niederhaltelitze 5 ist mit ihrem einen Ende 10 in der an der von der Solarzelle 2 abgewandten Oberseite der Stirnseite S2 gehaltenen Befestigungseinrichtung 7 fixiert bzw. geklemmt und an ihrem anderen Ende 11 mit der an der Oberseite der Stirnseite S1 zugeordneten Kraftausgleichseinrichtung 8 verbunden, so dass die Niederhaltelitze 5 zwischen Befestigungseinrichtung 7 und Kraftausgleichseinrichtung 8 eingespannt und ständig unter einer bestimmten Vorspannung gehalten ist. Die so fixierten und gespannten Niederhaltelitzen 5 überspannen das Rahmenfeld 9 des Spannrahmens 4 an seiner der Solarzelle 2 zugewandten Seite quer zur Transportrichtung TR und bilden einen in Breitenrichtung und Längsrichtung der Verbinder 3 linear wirkenden Niederhalter.
Die elastischen Niederhaltelitzen 4 bestehen aus geflochten Edelstahlfäden oder einem anderen geeigneten Material, das eine ausreichende Temperaturbeständigkeit bei Lötvorgängen besitzt.

In dem in Fig. 1 dargestellten Beispiel ist jede Niederhaltelitze 5 mit drei Kontakteinheiten 6 versehen, die so zueinander ausgerichtet sind, dass ihre Lage auf die Position der abgelegten Verbinder 3 eingestellt ist.

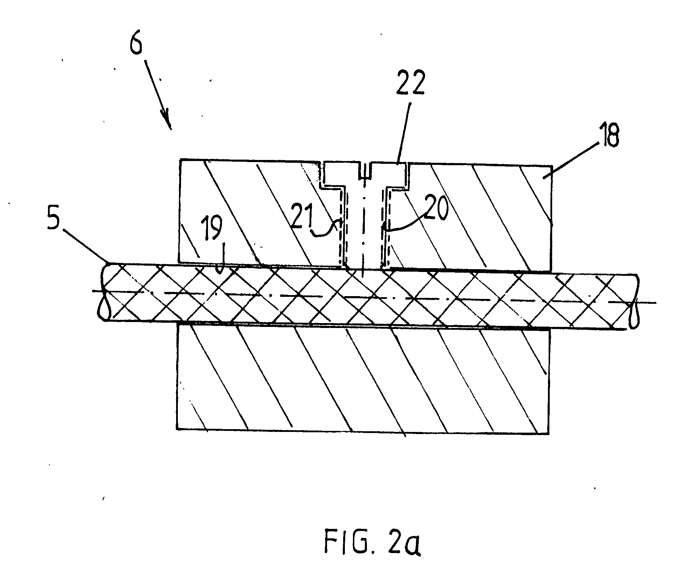

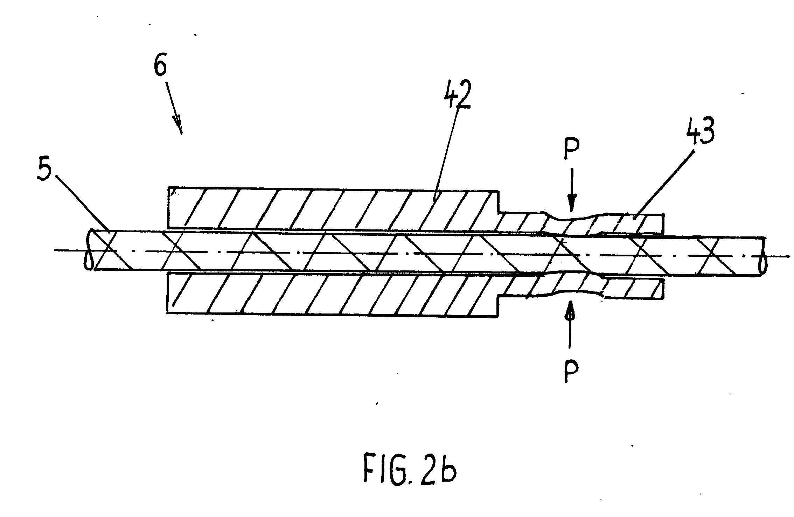

Jede Kontakteinheit 6 besteht - wie Fig. 2a zeigtaus einem metallischen Zylinder 18, der eine Durchführung 19 besitzt, die in der Zylinderachse angeordnet ist. Die Durchführung 19 hat einen Innendurchmesser, der mit dem Außendurchmesser der Niederhaltelitze 5 abgestimmt ist, so dass die Niederhaltelitze 5 in die Durchführung 19 ein- und hindurchgeführt werden kann. In den Zylindermantel des Zylinders 18 ist eine senkrecht zur Durchführung 19 angeordnete Bohrung 20 mit Innengewinde 21 eingebracht, in das eine Feststellschraube 22 zum Fixieren der Kontakteinheit 6 an der Niederhaltelitze 5 einschraubbar ist. Die Kontakteinheiten 6 können dadurch sehr einfach auf die unterschiedlichen Positionen der auf der Solarzelle 2 befindlichen Verbinder 3 eingestellt werden.
Die Kontakteinheiten 6 können weiterhin verschiedene Längen und Außendurchmesser besitzen, wodurch es problemlos möglich ist, die erfindungsgemäße Vorrichtung auf unterschiedlich breite Verbinder anzupassen.
Die Kontakteinheit 6 kann aber auch gemäß Fig. 2b aus einem Walzenkörper 42 mit einer axialen Durchführung 19 gebildet sein, die auf den Durchmesser der Niederhaltelitze 5 abgestimmt ist. Dieser Walzenkörper 42 besitzt in Flucht der axialen Durchführung 19 mindestens an einer Stirnseite einen angeformten Zapfen 43, durch die die Durchführung 19 ebenso geführt ist. Der Zapfen 43 ist deformierbar und kann durch eine von außen aufgebrachte Verformungskraft P so verformt werden, dass der Zapfen 43 die Niederhaltelitze 5 in der Durchführung 19 entsprechend der Position der Verbinder 3 klemmt und unverrückbar fixiert.
Als Werkstoff für die Kontakteinheiten 6 sind vorzugsweise metallische Materialien, beispielsweise Edelstahl geeignet, die bei Lötvorgängen eine ausreichende Temperaturbeständigkeit haben.

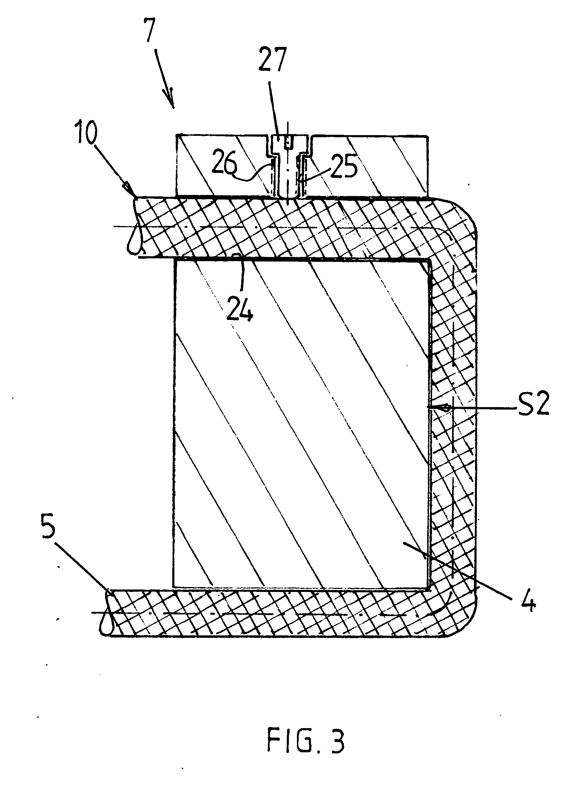

Fig. 3 zeigt einen Schnitt durch die Befestigungseinrichtung 7.
Die Befestigungseinrichtung 7 besteht aus einer Klemmanordnung 23, die der Stirnseite S2 des Spannrahmens 4 zugeordnet ist.
Die Klemmanordnung 23 kann beispielsweise in den Rahmen 4 eingebracht oder separat am Rahmen 4 befestigt sein. Sie besteht aus einer Durchführung 24 in der Stirnseite S2 des Rahmens 4 oder aus einem am Rahmen 4 befestigten Klemmstück mit der Durchführung 24, in die das Ende 10 der Niederhaltelitze 5 ein- und hindurchgeführt werden kann. In der Stirnseite S2 des Rahmens 4 oder im Klemmstück 23 ist eine senkrecht zur Durchführung 24 angeordnete Bohrung 25 mit Innengewinde 26 eingebracht, in die eine Feststellschraube 27 zum Fixieren des Endes 10 der Niederhaltelitze 5 eingeschraubt werden kann, so dass das Ende 10 fest fixiert ist.

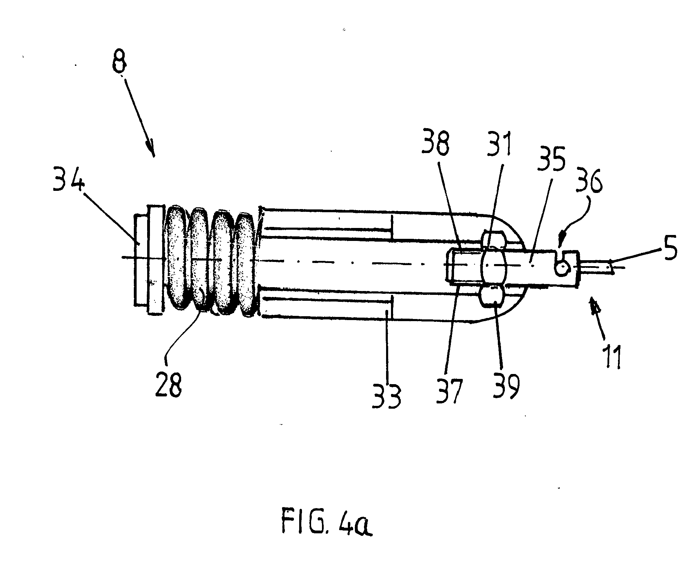

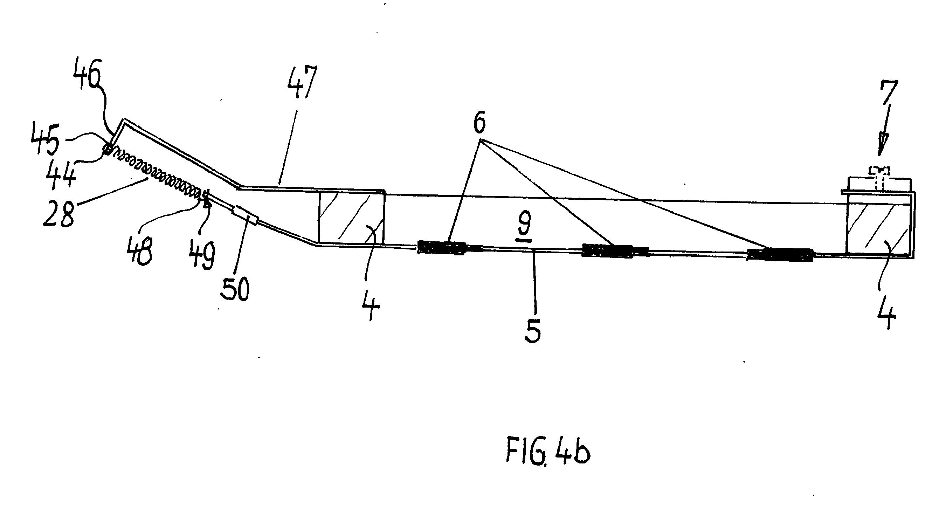

Die Fig. 4a zeigt eine Variante der Kraftausgleichseinrichtung 8 in einer vergrößerten Schnittdarstellung.
Die Kraftausgleichseinrichtung 8 umfasst eine Druckfeder 28, ein hülsenförmiges Zugglied 33 für die Druckfeder 28, dessen eine nicht gezeigte Öse vom Zugglied 33 gehalten ist, ein vom Zugglied 33 gehaltenes Befestigungsteil 34 für die andere ebenfalls nicht dargestellte, dem Ende 11 der Niederhaltelitze 5 zugeordnete Öse der Druckfeder 28 und ein am Zugglied 33 befestigtes Einhängteil 35 für die Aufnahme des Endes 11 der Niederhaltelitze 5.
Das Einhängteil 35 hat an seinem der Niederhaltelitze 5 zugewandten Ende 11 eine Einhängöffnung 36, in die das verdickte Ende 10 der Niederhaltelitze 5 einhäng- oder aushängbar ist.
Das Einhängteil 36 besteht aus einem bolzenartigen Schaftteil 37 mit Außengewinde 38, das in einer vom hülsenförmigen Zugglied 33 gehaltenen Mutter 39 mit entsprechend zum Außengewinde 38 angepassten Innengewinde 31 eingeschraubt ist, wodurch sich die Vorspannung der Druckfeder 28 einstellen lässt.
Die Kraftausgleichseinrichtung 8 kann aber -wie Fig. 4b zeigt- eine Zugfeder 28 umfassen, deren eine Öse 44 in einer Öffnung 45 eines zu einer an der Stirnseite S2 befestigten Leiste 46 gehörenden, vom Transportband 1 weg abgewinkelten Schenkels 47 und dessen andere Öse 48 in einer Öffnung 49 eines mit dem Ende 11 der Niederhaltelitze 5 verstellbar verbundenen Zuggliedes 48 eingehängt ist.

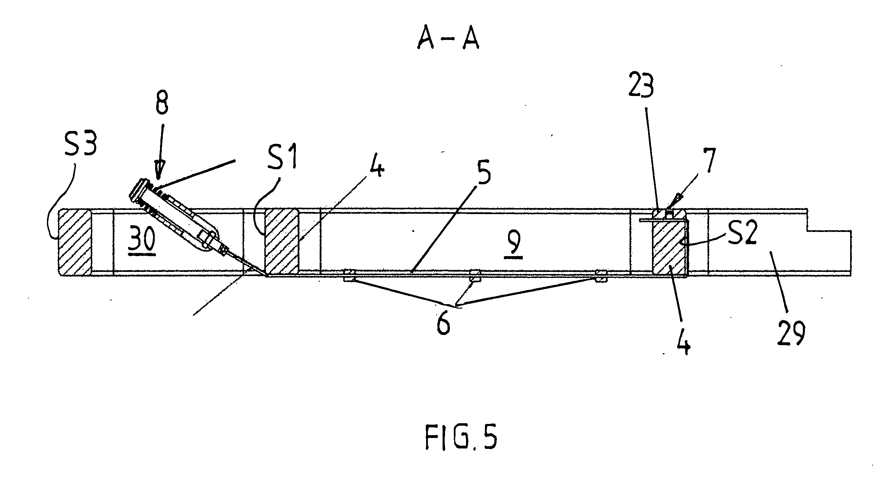

In Fig. 5 ist der Schnitt A-A nach Fig. 1 gezeigt. Der Spannrahmen 4 besitzt wie in Abschnitt [0026] beschrieben neben dem Rahmenfeld 9 ein weiteres Aufnahmefeld 30 für die Befestigung der Kraftausgleichseinrichtungen 8.
An den Längsseiten LS dieses Aufnahmefeldes 30 ist eine Leiste 32 befestigt, die parallel zur äußeren Stirnseite S3, jedoch quer zu den Längsseiten LS angeordnet ist und die Kraftausgleichsrichtungen 8 in einer vom Transportband 1 weg geneigten Ebene trägt.
Jeder Niederhaltelitze 5 ist eine Kraftausgleichseinrichtung 8 zugeordnet, die jeweils genau in Flucht der Durchführung 24 der Befestigungseinrichtung 7 liegt, so dass die elastische Niederhaltelitze 5 eingespannt ist und beim Absenken des Spannrahmens 4 mit Niederhaltelitze 5 und Kontakteinheit 6 auf die Verbinder 3 mit etwa gleicher Auflagekraft drückt. Die Kraftausgleichseinrichtung 8 hält die Vorspannung der Niederhaltelitze 5 unabhängig von äußeren Einflüssen etwa konstant. Beim Absenken legen sich die Kontakteinheiten 6 auf die Verbinder 3 auf und die Niederhaltelitze 5 wird weiter gespannt. Die Niederhaltekraft entsteht dann durch den vertikalen Relativanteil der Spannkraft, was bedeutet, dass beim Aufsetzen der Kontakteinheiten 6 keine horizontale Relativbewegung erzeugt wird. Die beidseitige Einspannung der Niederhaltelitze 5 gewährleistet eine quasi lineare Vertikalbewegung.
Durch das gesamtelastische System sowohl entlang einer Niederhaltelitze 5 als auch der voneinander unabhängig nebeneinander angeordneten Niederhaltelitzen 5 werden Unebenheiten der Solarzellen und der Verbinder ausgeglichen. Die erfindungsgemäße Vorrichtung hat des Weiteren den Vorteil, dass sie für Kontaktlötverfahren und auch kontaktfreie Lötverfahren gleichermaßen nutzbar ist.

Bezugszeichenliste
- Transportband: 1
- Solarzelle: 2
- Verbinder: 3
- Spannrahmen, Rahmen: 4
- Niederhaltelitze: 5
- Kontakteinheit: 6
- Befestigungseinrichtung: 7
- Kraftausgleichseinrichtung: 8
- Rahmenfeld: 9
- Ende von 5: 10, 11
- Haltelement: 12
- Säulen: 13
- Führung für 14: 14
- Pneumatischer Antrieb: 15
- Linearsystem: 16
- Antrieb für 16: 17
- Zylinder: 18
- Durchführung von 18: 19
- Bohrung in 18: 20
- Innengewinde in 20: 21
- Feststellschraube: 22
- Klemmanordnung, Klemmstück: 23
- Durchführung in 23: 24
- Bohrung in 23: 25
- Innengewinde in 24: 26
- Feststellschraube: 27
- Zugfeder, Druckfeder: 28
- Haltearme: 29
- Aufnahmefeld: 30
- Innengewinde von 39: 31
- Leiste: 32
- Hülsenförmiges Zugglied: 33
- Befestigungsteil: 34
- Einhängteil: 35
- Einhängöffnung: 36
- Schaftteil: 37
- Außengewinde von 37: 38
- Mutter: 39
- Laufrollen: 40
- Laufschiene: 41
- Walzenkörper: 42
- Zapfen von 42: 43
- Ösen von Zugfeder 28: 44, 48
- Öffnung in 46: 45
- Leiste: 46
- Schenkel: 47
- Öffnung in Zugglied 50: 49
- Zugglied: 50
- Breite von 3: B
- Länge von 3: L
- Längsseite von 4: LS
- Niederhalter: N
- Verformungskraft: P
- Stirnseiten von 4: S1, S2, S3
- Transportrichtung: TR

## Patentansprüche

1. Vorrichtung zum Lagefixieren eines Verbinders (3) aus verzinntem Lötband auf einer Solarzelle (2) mittels eines auf den Verbinder absenkbaren Niederhalters (N) beim Transport in einer Fertigungsanlage zur Herstellung von Solarzellenstrings, mit einem von einem Antrieb angetriebenen Transportband (1) zum Bewegen von Solarzelle (2) und Verbinder (3) zu einer Bearbeitungsstation, wobei der zum Transportband (1) synchron bewegte Niederhalter (N) ein mit Niederhalteelemente versehenen Rahmen (4) aufweist, **dadurch gekennzeichnet, dass** der Rahmen (4) als ein mit seinen Längsseiten (LS) quer zur Transportrichtung (TR) des Transportbandes (1) angeordneter federrostartiger Spannrahmen ausgebildet ist, zwischen dessen parallel zur Transportband (1) angeordnete Stirnseiten (S1, S2) mindestens eine zum Verbinder (3) quer und zugewandt angeordnete elastische Niederhaltelitze (5) unter Spannung in einem Rahmenfeld (9) des Spannrahmens gehalten ist, und dass die Niederhaltelitze (5) mindestens eine Kontakteinheit (6) zum linearen Andrücken des Verbinders (3) an die Solarzelle (2) beim Absenken aufweist.

2. Vorrichtung nach Anspruch 1, **dadurch gekennzeichnet, dass** eine Vielzahl von Niederhaltelitzen (5) entsprechend der Länge (L) der Verbinder (3) in Transportrichtung (TR) hintereinander, aber voneinander beabstandet entlang der Stirnseiten (S1, S2) des Rahmens (4) angeordnet sind, wobei die in Richtung eines jeden Verbinders (3) hintereinander liegenden Kontakteinheiten (6) aller Niederhaltelitzen (5) den jeweiligen Verbinder (3) jeweils linear über seine Länge (L) in Transportrichtung (TR) und die Kontakteinheiten (6) einer Niederhaltelitze (5) nebeneinander liegende Verbinder (3) quer zur Transportrichtung (TR) jeweils über seine Breite (B) unabhängig voneinander an die Solarzelle (2) drücken.

3. Vorrichtung nach Anspruch 1, **dadurch gekennzeichnet, dass** jede Niederhaltelitze (5) an ihrem einen Ende (10) mit einer an der Stirnseite (S2) festgelegten Befestigungseinrichtung (7) und an ihrem anderen Ende (11) mit einer entlang der Stirnseite (S1) angeordneten Kraftausgleichseinrichtung (8) zum Einstellen der Spannkraft der Niederhaltelitze (5) verbunden ist

4. Vorrichtung nach Anspruch 1, **dadurch gekennzeichnet, dass** der Rahmen (4) ein von den Längsseiten (LS) und einer weiteren Stirnseite (S3) umgrenztes Aufnahmefeld (30) für die Aufnahme der Kraftausgleichseinrichtungen (8) ausbildet, die an einer quer zu den Längsseiten (LS), in einer vom Transportband (1) weg geneigten Ebene angeordneten Leiste (32) befestigt sind.

5. Vorrichtung nach Anspruch 1, **dadurch gekennzeichnet, dass** der Rahmen (4) an der entgegen der Transportrichtung (TR) abgewandten Längsseite (LS) offen ausgebildet ist und nur eine Längsseite (LS) aufweist, die der Transportrichtung (TR) zugewandt ist.

6. Vorrichtung nach Anspruch 3, **dadurch gekennzeichnet, dass** die Kraftausgleicheinrichtung (8) vorzugweise umfasst:
a) eine Druckfeder (28), die in an ihrem eine Ende in einem hülsenförmigen Zugglied (33) gehalten und an ihrem anderen Ende an einem Befestigungsteil 34 fixiert ist,
b) ein mit einer Einhängöffnung (36) für die Niederhaltelitze (5) versehenen Einhängteil (35), welches ein bolzenartiges Schaftteil (37) mit Außengewinde (38) aufweist, das in Achsrichtung des hülsenförmigen Zugglied (33) in einer am Zugglied befestigten Mutter (39) mit Innengewinde (31) zum Einstellen der Vorspannung der Druckfeder (28) einschraubbar gehalten ist.

7. Vorrichtung nach Anspruch 3, **dadurch gekennzeichnet, dass** die Kraftausgleicheinrichtung (8) vorzugweise eine Zugfeder (28) umfasst, deren eine Öse (44) in einer Öffnung (45) eines zu einer an der zweiten Stirnseite (S2) befestigten Leiste (46) gehörenden in Richtung Transportband (1) abgewinkelten Schenkels (47) und dessen andere Öse (48) in einer Öffnung (50)eines mit dem Ende (11) der Niederhaltelitze (5) verstellbar verbundenen Zuggliedes (50) eingehängt ist.

8. Vorrichtung nach Anspruch 1, **dadurch gekennzeichnet, dass** die Kontakteinheit (6) aus einem mit einer axialen Durchführung (19) für die Niederhaltelitze (5) versehenen Zylinderkörper (18) gebildet ist, der auf die Niederhaltelitze (5) aufgeschoben und entsprechend der Position des Verbinders (3) auf der Solarzelle (2) entlang der Niederhaltelitze (5) einstell- und fixierbar ist.

9. Vorrichtung nach Anspruch 7, **dadurch gekennzeichnet, dass** im Zylinder (18) eine senkrecht zur Durchführung (19) angeordnete Bohrung (20) mit Innengewinde (21) angeordnet ist, in das eine Feststellschraube (22) zum Fixieren der Kontakteinheit (6) an der Niederhaltelitze (5) einschraubbar ist.

10. Vorrichtung nach Anspruch 1, **dadurch gekennzeichnet, dass** die Kontakteinheit (6) als ein mit einer axiale Durchführung (19) aufweisender Walzenkörper (42) mit mindestens einem an einer Stirnseite angeformten Zapfen (43) ausgebildet, wobei der Zapfen (43) dünnwandig und so deformierbar ist, dass er durch eine von außen aufgebrachte Verformungskraft (P) auf der Niederhaltelitze (5) entsprechend der Position der Verbinder (3) geklemmt und fixiert ist.

11. Vorrichtung nach Anspruch 8 oder 10, **dadurch gekennzeichnet, dass** der Zylinderkörper (18) oder Walzenkörper (42) durchmesser- und längenvariabel ist und aus einem beim Löten temperaturbeständigen Werkstoff, vorzugsweise Edelstahl, besteht.

12. Vorrichtung nach Anspruch 3, **dadurch gekennzeichnet, dass** die Befestigungseinrichtung (7) für die Niederhaltelitze (5) eine an der zur Solarzelle (2) abgewandten Oberfläche der Stirnseite (S2) befestigte Klemmanordnung (23) mit einer Durchführung (24) umfasst, in die das Ende (10) der Niederhaltelitze (5) einsteck- und hindurchführbar ist, wobei die Niederhaltelitze (5) durch eine in eine senkrecht zur Durchführung (24) eingebrachte Bohrung (25) mit Innengewinde (26) eingeschraubte Feststellschraube (27) fixierbar ist.

13. Vorrichtung nach Anspruch 12, **dadurch gekennzeichnet, dass** die Klemmanordnung (22) als eine Leiste (32) ausgebildet ist, an der Klemmstücke befestigt sind, die entlang der Stirnseite (S2) des Spannrahmens (4) positioniert sind.

14. Vorrichtung nach Anspruch 12, **dadurch gekennzeichnet, dass** die Klemmanordnung (22) direkt in die an der der Solarzelle (2) abgewandten Oberseite der Stirnseite (S2) integriert ist.

15. Vorrichtung nach Anspruch 1, **dadurch gekennzeichnet, dass** die Niederhaltelitze (5) aus einem Material besteht, das elastische Eigenschaften auch bei höheren Temperaturen, vorzugsweise Löttemperaturen, besitzt, vorzugsweise geflochtene Metallfäden, insbesondere Edelstahlfäden, temperaturbeständige Kunststofffäden oder Fäden aus Kompositwerkstoffen.

16. Vorrichtung nach Anspruch 1, **dadurch gekennzeichnet, dass** der Spannrahmen (4) mit senkrecht zur Transportrichtung (TR) angeordneten Säulen (13) und einem Antrieb (15) zum vertikalem Absenken oder Anheben auf die bzw. von den Solarzellen (2) versehen sind, wobei Spannrahmen (4), Säulen (13) und Antrieb (15) in einer in Transportrichtung (TR) horizontal verlaufenden Linearführung (16) durch einen mit dem Antrieb des Transportbandes (1) synchronisierten Antrieb (17) geführt sind.

17. Vorrichtung nach Anspruch 16, **dadurch gekennzeichnet, dass** der Antrieb (15) ein pneumatischer, hydraulischer oder elektrischer Antrieb ist.
